# EUROPEAN PATENT APPLICATION

(11) **EP 4 456 096 A1**
(43) Date of publication of application: **30.10.2024**
(21) Application number: 24170511.0
(22) Date of filing: 16.04.2024
(51) Int. Cl.: H01F 27/28, H01J 49/02, H01F 38/08

(54) **POWER SUPPLY, MAGNETIC CORE TRANSFORMER, AND PCB**

(30) Priority: 26.04.2023 KR 20230054624
(71) Applicant: Young In Ace Co., Ltd., Anyang-si, Gyeonggi-do 14042 (KR)
(72) Inventor: OSIPOV, Vadim, 14077 Gyeonggi-do (KR); KIM, Eun Do, 14316 Gyeonggi-do (KR); KANG, Sung Won, 14079 Gyeonggi-do (KR)
(74) Representative: Kuhnen & Wacker Patent- und Rechtsanwaltsbüro PartG mbB

(57) **Abstract**

Disclosed is a power supply including an RF power source, a magnetic core transformer including a first transformer and a second transformer, each of which boosts an output of the RF power source. Each of the first transformer and the second transformer includes an input coil, a magnetic core, and an output coil. The input coil includes an outer winding and inner winding. The outer winding and inner winding form a single turn winding, and the outer winding and the inner winding are connected in series to each other.

## Description

### CROSS-REFERENCE TO RELATED APPLICATIONS

This application claims priority under 35 U.S.C. § 119 to Korean Patent Application No. 10-2023-0054624 filed on April 26, 2023, in the Korean Intellectual Property Office, the disclosures of which are incorporated by reference herein in their entireties.

### BACKGROUND

Embodiments of the present disclosure described herein relate to a power supply, and more particularly, relate to a power supply used in a mass spectrometer.

A mass spectrometer is an instrument that identifies or analyzes chemical agents, etc. for mass analysis. The mass spectrometer may analyze the composition of a sample by measuring the mass of a substance through a mass-to-charge ratio. Samples may be ionized within the mass spectrometer in a variety of methods. The ionized samples may be accelerated while passing through an electric and/or magnetic field. In other words, the path of part or all of the ionized samples may be bent by an electric field and/or a magnetic field. A detector may detect the ionized sample.

In quadrupole mass spectrometry, a DC voltage and a RF voltage may be applied to a quadrupole. The power supply may amplify the output of an RF power source through a transformer and may apply the amplified output to the quadrupole. An air core transformer is used as the transformer that amplifies the output of the RF power source. In this case, a method of reducing a size is required while a transformer factor corresponding to a transformation ratio is maintained.

### SUMMARY

Embodiments of the present disclosure provide a small transformer and a power supply including the small transformer while a transformer factor is maintained.

Problems to be solved by the present disclosure are not limited to the problems mentioned above, and other problems not mentioned will be clearly understood by those skilled in the art from the following description.

According to an embodiment, a power supply includes an RF power source, a magnetic core transformer including a first transformer and a second transformer, each of which boosts an output of the RF power source, DC decoupling capacitors connected between a ground and a first terminal among output terminals of the first transformer and the second transformer, variable capacitors connected between the ground and a second terminal among the output terminals of the first transformer and the second transformer, a DC power source configured to provide a DC voltage to the first terminal, an output terminal configured to output the DC voltage and a boosted RF voltage. Each of the first transformer and the second transformer includes an input coil, a magnetic core, and an output coil. The input coil includes an outer winding and an inner winding. The outer winding and the inner winding form a single turn winding, and the outer winding and the inner winding are connected in series to each other.

According to an embodiment, a printed circuit board (PCB) includes a board, a first conductive line placed on one surface of the board, and a second conductive line placed on a surface opposite to the one surface of the board. The first conductive line includes an inner winding and an outer winding, and the inner winding and the outer winding form a single turn winding, and the outer winding and the inner winding are connected in series to each other.

According to an embodiment, a magnetic core transformer includes a first magnetic core, a second magnetic core, and a first printed circuit board and a second printed circuit board. A first conductive line is placed on one surface of each of the first printed circuit board and the second printed circuit board, and a second conductive line is placed on a surface opposite to the one surface. The first conductive line includes an inner winding and an outer winding, and the inner winding and the outer winding form a single turn winding, and the outer winding and the inner winding are connected in series to each other.

### BRIEF DESCRIPTION OF THE FIGURES

The above and other objects and features of the present disclosure will become apparent by describing in detail embodiments thereof with reference to the accompanying drawings.
FIG. 1 is a circuit diagram showing a power supply of a mass spectrometer.
FIG. 2 is a circuit diagram showing a power supply of a mass spectrometer, according to an embodiment of the present disclosure.
FIG. 3 is a diagram showing a vertical cross-section of the magnetic core transformer of FIG. 2.
FIG. 4 is a diagram showing a magnetic core and a printed circuit board of the magnetic core transformer of FIG. 3.
FIGS. 5A and 5B are plan views of coils of a first conductive line and a second conductive line of a printed circuit board included in a magnetic core transformer, according to an embodiment of the present disclosure.
FIGS. 6A and 6b are an exploded perspective view and a combination diagram of the magnetic core transformer of FIG. 3.
FIG. 7 is a diagram showing a magnetic field formed by an input coil and an output coil of a magnetic core transformer of FIG. 3.
FIG. 8 is an RF equivalent circuit of the power supply of FIG. 2.
FIGS. 9A to 9C are graphs showing characteristics of the RF equivalent circuit of FIG. 8.

### DETAILED DESCRIPTION

To fully understand the composition and effectiveness of the present disclosure, preferred embodiments of the present disclosure will be described in detail with reference to the accompanying drawings.

The present disclosure is not limited to embodiments disclosed below, but may be implemented in many forms and subject to various modifications and changes. However, the description of the embodiments is provided to make the disclosure of the present disclosure complete and to fully disclose the scope of the present disclosure to those having ordinary skill in the art to which it belongs. In the accompanying drawings, the components are shown to scale for illustrative purposes only, and the proportions of each component may be exaggerated or reduced.

The terms used herein are provided to describe embodiments, not intended to limit the present disclosure. Moreover, terms used herein may be construed to have the meanings commonly known to one of ordinary skill in the art, unless otherwise defined.

In the present disclosure, the singular forms include plural forms unless particularly mentioned. The terms "comprises" and/or "comprising," when used in the specification, specify the presence of steps, operations, elements, and/or components, but do not preclude the presence or addition of one or more other steps, operations, elements, components, and/or groups thereof.

When it is described in the present disclosure that a layer is "on top of" another layer, it may be formed directly on top of the other layer or a third layer may be interposed therebetween.

In the present disclosure, terminologies such as first, second, etc. and the like used to describe various regions, layers, and the like, these regions, layers, and the like should not be limited by terminologies terms. These terminologies are only used to distinguish one region, or layer from another region or layer. Accordingly, a portion referred to as the first part in an embodiment may be referred to as the second part in another embodiment. The embodiments described herein include complementary embodiments thereof. Throughout the specification, portions marked with the same reference number refer to the same components.

Hereinafter, embodiments of a power supply according to an embodiment of the present disclosure will be described in detail with reference to the drawings.

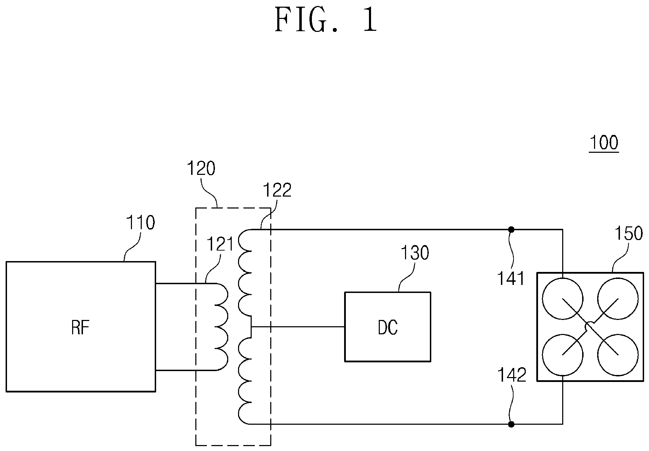

FIG. 1 is a circuit diagram showing a power supply of a mass spectrometer. Referring to FIG. 1, a power supply 100 of a mass spectrometer may include an RF power source 110, a transformer 120, a DC power source 130, output terminals 141 and 142, and a quadrupole mass filter 150.

The RF power source 110 generates an RF voltage, which is a high frequency and which has relatively small in level compared to the output of the power supply 100. The RF voltage generated by the RF power source 110 may be boosted to the RF voltage having a relatively great level through the transformer 120.

The transformer 120 may include an input coil 121 and an output coil 122. The RF voltage generated from the RF power source is applied to the input coil. The RF voltage applied to the input coil forms a magnetic flux, and the induced electromotive force due to the magnetic flux is applied to the output coil 122. The output coil 122 may be a split inductor and may generate a differential RF voltage.

The DC power source 130 adds a direct current (DC) component to an output voltage through the output coil 122. In this case, the DC voltage component generated through the DC power source and an RF component delivered through the output coil 122 may be applied to the quadrupole mass filter 150 through the output terminals 141 and 142.

The differential RF voltage and the DC voltage may be applied to the output terminals 141 and 142. The frequency of the RF output through the output terminals 141 and 142 may be several megahertz (MHz), and the amplitude of an RF output voltage may be several kilovolts (KV). The voltage of the DC output through the output terminals 141 and 142 may be several hundred volts (V). The output terminals 141 and 142 may deliver differential RF and DC voltages to the quadrupole mass filter 150.

The quadrupole mass filter 150 may include four cylindrical rods arranged in parallel with each other. The same power source is applied to rods arranged diagonally, and the differential RF and DC voltages are applied to rods arranged adjacently. An electromagnetic field is formed in the quadrupole mass filter 150, and ions with various masses are sprayed between rods with the same energy. The Ions within the quadrupole mass filter 150 may be separated according to mass. In this way, the mass of an ion may be analyzed.

The transformer 120 needs to satisfy following three requirements. First, the output coil 122 of the transformer 120 needs to provide resonance with another capacitive element at an operating frequency. Second, the output coil 122 needs to withstand a high voltage. Third, the inductive coupling between the input coil 121 and the output coil 122 needs to be small enough to match the RF power source 110, which generates a relatively low voltage. The inductive coupling in the transformer 120 may be an electrical interaction that occurs by sharing magnetic fields or flux between the input coil 121 and the output coil 122, and may be expressed as a coupling factor with a value between 0 and 1. The transformer factor may be determined according to the number of turns and sensitivity of the input coil 121 and the output coil 122. As the transformer factor is high, the magnetic field generated in the input coil 121 may be delivered to the output coil 122, and thus the output voltage of the transformer 120 may be amplified. The fact that the inductive coupling between the input coil 121 and the output coil 122 needs to be sufficiently small may mean that the transformer factor needs to be large enough.

An air core transformer capable of being applied to the transformer 120 may have a high Q value, which is a quality factor associated with loss due to resistance. However, the size of the transformer 120 may be greater than other types of transformers. To reduce the size of the transformer 120 and to maintain the Q value, a magnetic core may be applied to the transformer 120. For example, various types of magnetic cores, such as a silicon steel plate core or a ferrite core, may be applied to the transformer 120. The ferrite core is a core made of pressed iron powder material, and has less eddy current loss from in high-frequency power source than the silicon steel plate core.

When a magnetic core is applied to the transformer 120, the three requirements described above need to be satisfied. In this case, the fact that the output coil 122 needs to provide resonance with another capacitive element at an operating frequency may mean that the three requirements may be satisfied by determining the air gap of the magnetic core and the turns ratio of the input coil 121 and the output coil 122.

The fact that the output coil 122 of the magnetic core transformer needs to withstand a high voltage may mean that the three requirements may be satisfied by selecting a creepage distance between adjacent windings of the output coil 122 and adjusting the air gap of the magnetic core.

The fact that the inductive coupling between the input coil 121 and the output coil 122 needs to be small enough to match the RF power source 110 may mean that the three requirements may be satisfied by increasing a transformer factor. In this case, the following two methods may be considered to increase the factor of a transformer.

First, the turns ratio of the input coil 121 and the output coil 122 may be increased. However, as the number of turns of the output coil 122 increases, the self-inductance of the output coil 122 increases in proportion to the square of the number of turns, and thus there are limitations in forming resonance with capacitive elements. Also, the number of turns of the input coil 121 may not be smaller than 1. Accordingly, increasing the turns ratio is limited.

Second, the coupling factor between the input coil 121 and the output coil 122 of the transformer 120 may be reduced. When the transformer 120 is an air core transformer, the coupling factor may be reduced by reducing the area of the input coil 121, moving the output coil 122 away from the input coil, or changing an angle formed by a geometric axis between the input coil 121 and the output coil 122. However, when a magnetic core is applied to reduce the size of the transformer 120, the magnetic flux formed by the input coil 121 is concentrated in the core, and thus reducing the coupling factor in the same way as the air core transformer is limited. Accordingly, a new method is required to reduce the coupling factor between the input coil 121 and the output coil 122.

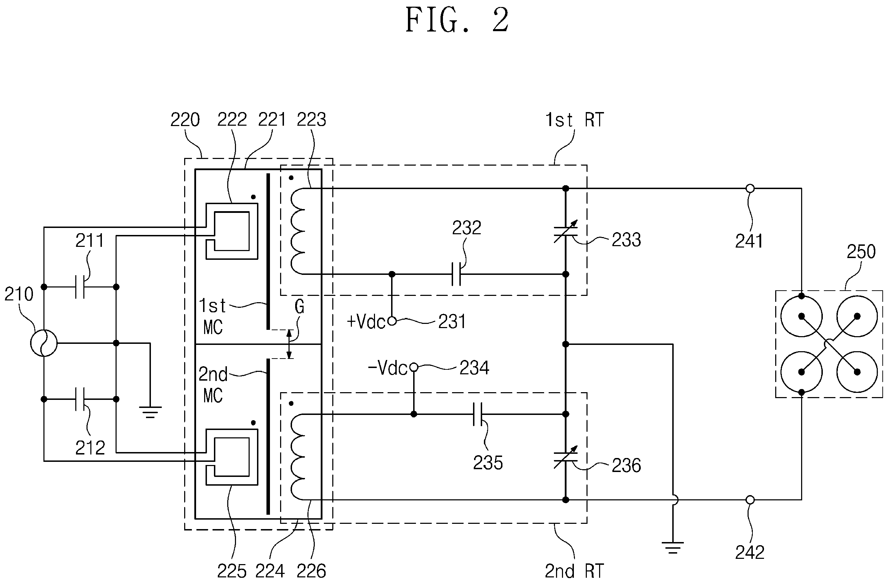

FIG. 2 is a circuit diagram showing a power supply of a mass spectrometer, according to an embodiment of the present disclosure. Referring to FIG. 2, a power supply according to an embodiment of the present disclosure may include an RF power source 210, matching capacitors 211 and 212, a magnetic core transformer 220, DC decoupling capacitors 232 and 235, variable capacitors 233 and 236, output terminals 241 and 242, and a quadrupole mass filter 250.

The RF power source 210 has a configuration corresponding to the RF power source 110 of FIG. 1 and generates an RF voltage of a relatively small level. The RF voltage generated from the RF power source 210 may be boosted to an RF voltage of a relatively great level through the magnetic core transformer 220.

The magnetic core transformer 220 may include a first transformer 221 and a second transformer 224. The first transformer 221 may include a part of a magnetic core MC, a first input coil 222, and a first output coil 223. The second transformer 224 may include other parts of the magnetic core MC, a second input coil 225, and a second output coil 226. The RF voltage generated by the RF power source 210 may be input to the first input coil 222 and the second input coil 225.

The first input coil 222 and the second input coil 225 may form magnetic flux concentrated in the magnetic core MC. The first output coil 223 and the second output coil 226 may output the voltage induced by the magnetic flux formed in the magnetic core MC. The first input coil 222 and the second input coil 225 may have the same shape. The first output coil 223 and the second output coil 226 may also have the same shape. An air gap G may be formed in the magnetic core MC.

Each of the first input coil 222 and the second input coil 225 may include an inner winding and an outer winding. The inner winding and the outer winding may consist of a single turn winding connected in series. Due to the structure of the first input coil 222 and the second input coil 225, a leakage inductance may be added to the first input coil 222 and the second input coil 225. The leakage inductance operates as a new magnetic inductance connected in series.

The matching capacitors 211 and 212 are respectively connected in parallel to the first input coil 222 and the second input coil 225 to compensate for the leakage inductance added by the structure of the first input coil 222 and the second input coil 225.

A DC voltage (e.g., +Vdc) of the first sign may be applied to a first DC terminal 231. A DC voltage (e.g., -Vdc) of a sign different from the first sign may be applied to a second DC terminal 234.

The DC decoupling capacitors 232 and 235 may connect RF voltage and DC voltage. In this case, the DC decoupling capacitors 232 and 235 may increase the accuracy of analysis by preventing a DC voltage from affecting the RF voltage.

The variable capacitors 233 and 236 are connected between a ground and the output terminals 241 and 242, respectively. The first output coil 223, the DC decoupling capacitor 232, and the variable capacitor 233 form a first resonance tank 1 st RT.

The second output coil 226, the DC decoupling capacitor 235, and the variable capacitor 236 form a second resonance tank 2nd RT. The first resonance tank 1st RT and the second resonance tank 2nd RT allow the RF output at the operating frequency of the magnetic core transformer 220 to be efficiently delivered to the output terminals 241 and 242, respectively. The variable capacitors 233 and 236 may be adjusted to provide resonance at the operating frequency.

The output terminals 241 and 242 may correspond to the output terminals 141 and 142 in FIG. 1, respectively. A differential RF voltage and a DC voltage may be applied to the quadrupole mass filter 250 through the output terminals 241 and 242, respectively.

The quadrupole mass filter 250 may correspond to the quadrupole mass filter 150 of FIG. 1.

In the meantime, while satisfying requirements of a transformer, the magnetic core transformer 220 according to an embodiment of the present disclosure may have a relatively small size through the structure of the first input coil 222 and the second input coil 225.

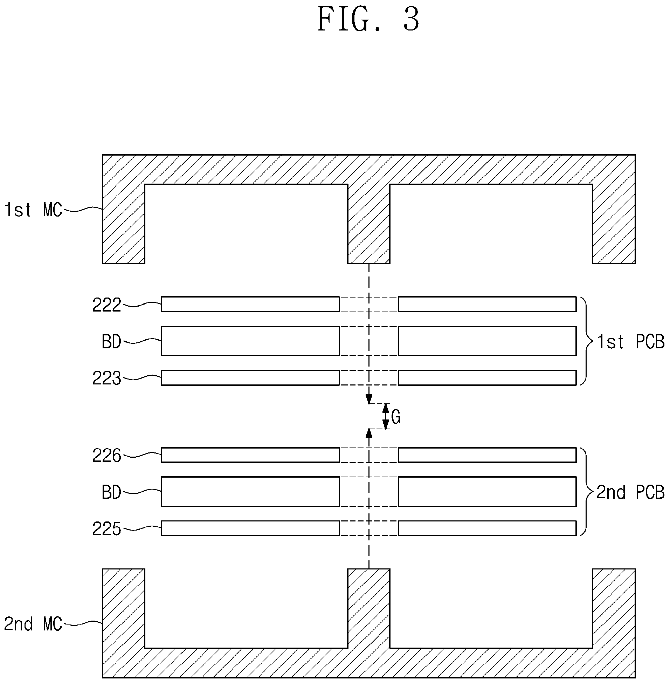

FIG. 3 is a diagram showing a vertical cross-section of the magnetic core transformer of FIG. 2. Referring to FIG. 3, the magnetic core transformer 220 of FIG. 2 may include a first magnetic core 1st MC, a second magnetic core 2nd MC, a first printed circuit board 1st PCB, and a second printed circuit board 2nd PCB.

The first magnetic core 1st MC and the second magnetic core 2nd MC may be E-shaped cores. Central protrusion parts of the first magnetic core 1st MC and the second magnetic core 2nd MC may pass through holes formed in centers of the first printed circuit board and the second printed circuit board, and may be spaced apart from each other by the air gap G. Similarly to the central protrusion parts, side protrusion parts of the first magnetic core 1st MC and the second magnetic core 2nd MC may be spaced apart from each other by the air gap G on both sides of the first printed circuit board and the second printed circuit board. The air gap between the central protrusion parts and the air gap G between the side protrusion parts may be identically formed or may be formed differently. The air gap G formed between the first magnetic core 1st MC and the second magnetic core 2nd MC may be determined by comprehensively considering resonance at an operating frequency and a high voltage applied to an output coil.

In the meantime, unlike the illustration of FIG. 3 where the first magnetic core 1st MC and the second magnetic core 2nd MC are shown symmetrically, the first magnetic core 1st MC and the second magnetic core 2nd MC may be formed in an asymmetric structure. For example, the length of the protrusion part of the first magnetic core 1st MC may be different from the length of the protrusion part of the second magnetic core 2nd MC. Alternatively, the first magnetic core 1st MC may be an E-shaped core, but the second magnetic core 2nd MC may be a shape that does not include a protrusion part.

The first printed circuit board 1st PCB may be the same as the second printed circuit board 2nd PCB.

The first printed circuit board 1st PCB may include a board BD, the first input coil 222, and the first output coil 223. A hole may be formed in the center of the board BD for inserting a magnetic core. The first input coil 222 may be placed on one surface of the first printed circuit board 1st PCB as a conductive line. The first output coil 223 may be formed on the other surface thereof as a conductive line. In other words, the conductive line of the first input coil 222 and the conductive line of the first output coil 223 may be placed on both sides of the board BD in a printed circuit method.

Similarly to the first printed circuit board 1st PCB, with respect to the second printed circuit board 2nd PCB, the conductive line of the second input coil 225 and the conductive line of the second output coil 226 may be formed on the board BD in the printed circuit method.

In the assembly of the magnetic core transformer 220, each of the first printed circuit board 1st PCB and the second printed circuit board 2nd PCB may be positioned such that the first input coil 222 and the second input coil 225 face outward. In other words, the first output coil 223 of the first printed circuit board 1st PCB and the second output coil 226 of the second printed circuit board 2nd PCB may be positioned to face each other. The coupling between the output coils 223 and 226 may be increased by placing the first output coil 223 and the second output coil 226 close to each other.

To prevent defects including short circuits between windings, from occurring due to a high voltage being induced on the board BD, an insulating material may be applied. To prevent insulation breakdown due to the high voltage, the first printed circuit board 1st PCB and the second printed circuit board 2nd PCB may be attached with an insulating adhesive including insulating plastic.

The first printed circuit board 1st PCB may correspond to the first transformer 221 in FIG. 2. The second printed circuit board 2nd PCB may correspond to the second transformer 224 of FIG. 2.

Various types of boards such as a FR-4 board, a CEM board, a metal core board, a polyimide board, a copper core board, a ceramic board, and a PTFE board may be used for the boards BD.

The conductive lines of the input coils 222 and 225 and the output coils 223 and 226 may be made of copper, gold, silver, aluminum, steel alloy, etc. In the meantime, the input coils 222 and 225 and the output coils 223 and 226 may be formed as a single multi-layer printed circuit board. The first magnetic core 1st MC and the second magnetic core 2nd MC may be ferrite cores.

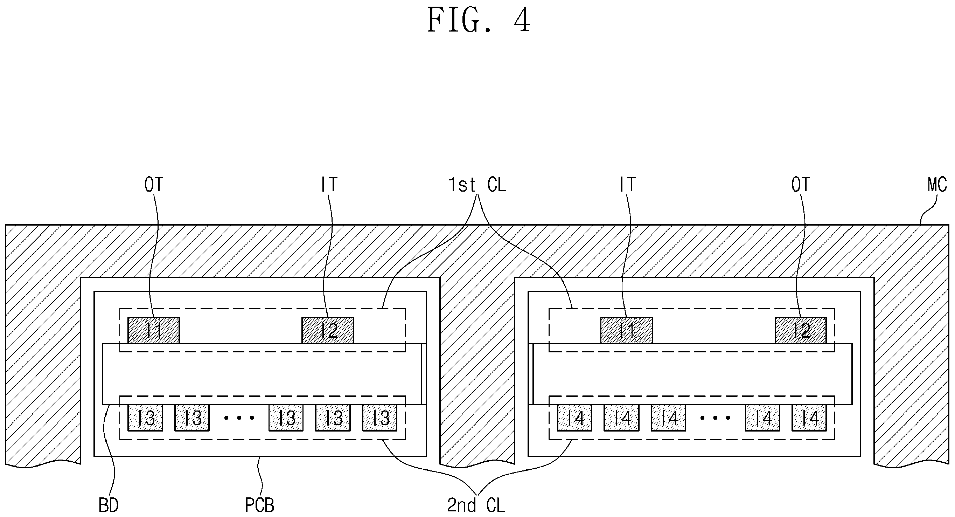

FIG. 4 is a diagram showing a magnetic core and a printed circuit board of the magnetic core transformer of FIG. 3. Referring to FIG. 4, the printed circuit board PCB may include the board BD and a first conductive line 1st CL and a second conductive line 2nd CL.

A hole may be formed in the center of the board BD such that a magnetic core MC passes through the hole. The first conductive line 1st CL may be a single turn winding and may have a structure in which an outer winding OT and an inner winding IT are connected in series. In this case, currents, which has the same magnitude and opposite directions, flow in the inner winding IT and the outer winding OT that are adjacent to each other. For example, currents I1 and I2 flowing in the first conductive line 1st CL have the same magnitude and opposite directions.

The second conductive line 2nd CL may be formed on a surface opposite to a surface on which the first conductive line 1st CL of the board BD is formed. The second conductive line 2nd CL may be a single-layer spiral coil having the specific number of turns. The number of turns of the second conductive line 2nd CL may be determined by comprehensively considering resonance at an operating frequency, a creepage distance for preventing insulation breakdown due to a high voltage, and a transformer factor.

The magnetic field of an inner region surrounded by the inner winding IT of the first conductive line 1st CL and the magnetic field of an outer region of the outer winding OT may decrease and may be magnetically coupled to the second conductive line 2nd CL. The magnetic field in a region between the inner winding IT and the outer winding OT is added, but is not magnetically coupled to the second conductive line 2nd CL. In this way, the coupling between the first conductive line 1st CL and the second conductive line 2nd CL may be small, and the certain amount of magnetic energy may not be delivered to the second conductive line 2nd CL, but may be stored only in the first conductive line 1st CL. That is, the mutual inductance between the first conductive line 1st CL and the second conductive line 2nd CL may decrease, and leakage inductance may be added to the first conductive line 1st CL. The leakage inductance operates as a new magnetic inductance connected in series to the first conductive line 1st CL. In other words, the coupling factor between the first conductive line 1st CL and the second conductive line 2nd CL may be reduced, thereby minimizing the number of turns of the second conductive line 2nd CL and increasing a transformer factor

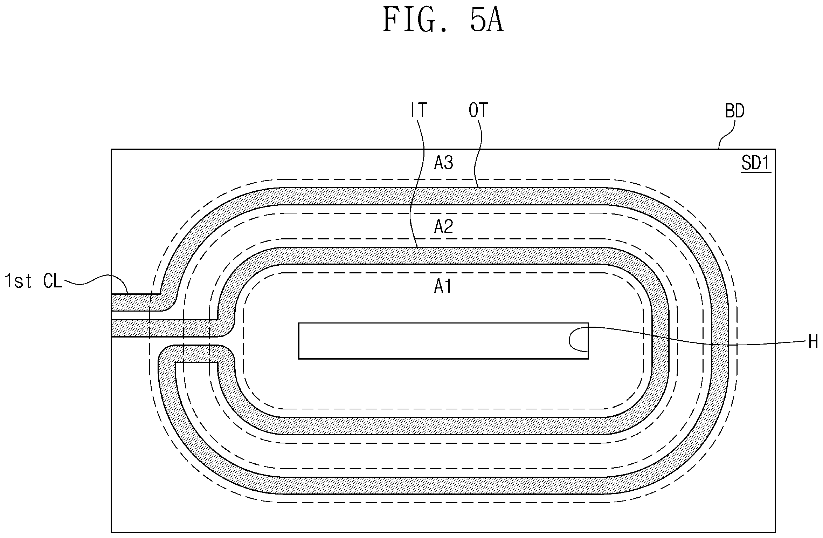

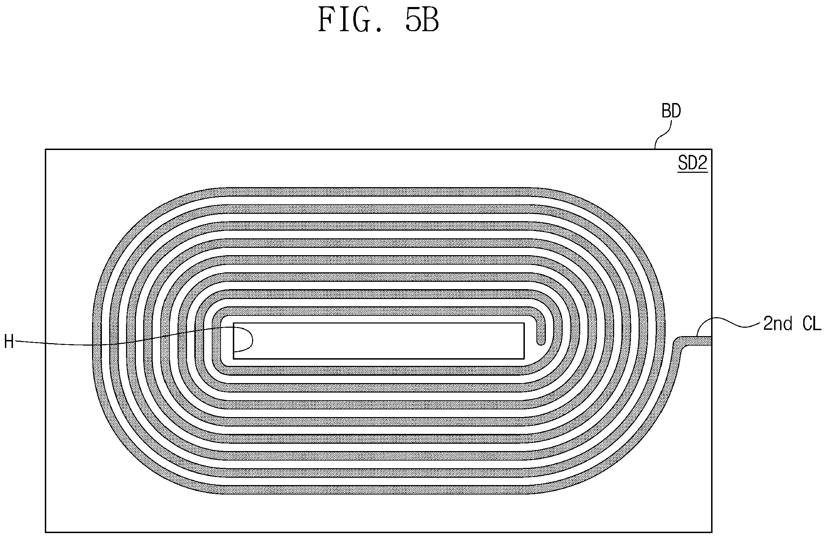

FIGS. 5A and 5B are plan views of coils of a first conductive line and a second conductive line of a printed circuit board included in a magnetic core transformer, according to an embodiment of the present disclosure. Referring to FIGS. 5A and 5B, the first conductive line 1st CL may include the outer winding OT and the inner winding IT, which are connected in series to each other and which form a single turn winding.

A hole H through which a magnetic core passes may be formed in the center of the board BD.

The first conductive line 1st CL may be placed on a first surface SD1 of the board BD. A region where the magnetic field is formed by the first conductive line 1st CL may be divided into a first region A1, a second region A2, and a third region A3 according to the inner winding IT and the outer winding OT. The first region A1 is an inner region of the inner winding IT; the second region A2 is a region between the inner winding IT and the outer winding OT; and, the third region A3 is an outer region of the outer winding OT.

The second conductive line 2nd CL may be placed on a second surface SD2 of the board BD. The second surface SD2 is the opposite surface of the first surface SD1. The second conductive line 2nd CL may be in a form of a spiral coil around the hole H formed in the center of a board.

As described in FIG. 4, the first conductive line 1st CL and the second conductive line 2nd CL are magnetically coupled to each other by the magnetic fields formed in the first region A1 and the third region A3 among magnetic fields formed at the RF voltage of the first conductive line 1st CL. On the other hand, the magnetic field formed in the second region A2 may not be coupled to the second conductive line 2nd CL and may form a leakage inductance. The leakage inductance in the second region may be treated as a magnetic inductance connected in series to the first conductive line 1st CL.

Due to the structure of the first conductive line 1st CL in which the inner winding IT and the outer winding OT are connected in series to each other as a single turn winding, the coupling factor between the first conductive line 1st CL and the second conductive line 2nd CL may be reduced. The transformer factor may be increased while the number of turns of the second conductive line 2nd CL is minimized.

The first conductive line 1 st CL may correspond to the first input coil 222 or the second input coil 225 of the magnetic core transformer 220 in FIG. 2. The second conductive line 2nd CL may correspond to the first output coil 223 or the second output coil 226 of the magnetic core transformer 220 of FIG. 2.

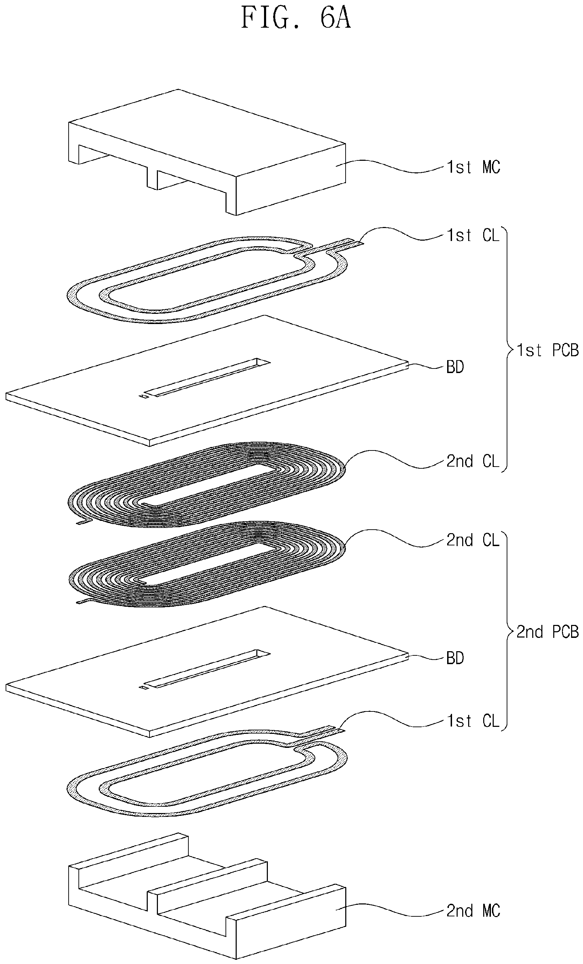

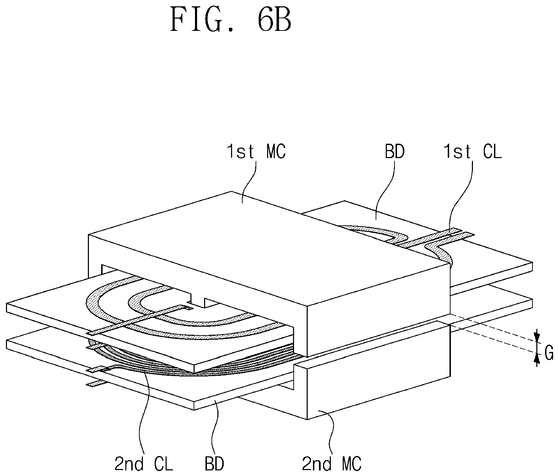

FIGS. 6A and 6b are an exploded perspective view and a combined diagram of the magnetic core transformer of FIG. 3. Referring to FIGS. 6A and 6B, the assembly of the magnetic core transformer 220 may be identified. The assembly of the magnetic core transformer 220 may be composed of the first magnetic core 1st MC, the second magnetic core 2nd MC, the first printed circuit board 1st PCB, and the second printed circuit board 2nd PCB.

Each of the first magnetic core 1st MC and the second magnetic core 2nd MC is an E-shaped magnetic core and has side protrusion parts and a central protrusion part. The central protrusion part of the first magnetic core 1st MC passes through a hole formed in the center of the first printed circuit board 1st PCB. The side protrusion parts cover side surfaces of the first printed circuit board 1st PCB. The first printed circuit board 1st PCB may be assembled with the first magnetic core 1st MC such that an input coil is located toward the first magnetic core 1st MC. The second magnetic core 2nd MC and the second printed circuit board 2nd PCB may also be assembled similarly as described above.

The air gap G may be formed between the first magnetic core 1st MC and the second magnetic core 2nd MC. The air gap G may be adjusted such that the RF voltage output by an output coil at an operating frequency is used to resonate with another capacitive element.

As described above, the first printed circuit board 1st PCB and the second printed circuit board 2nd PCB may be attached with insulating adhesive.

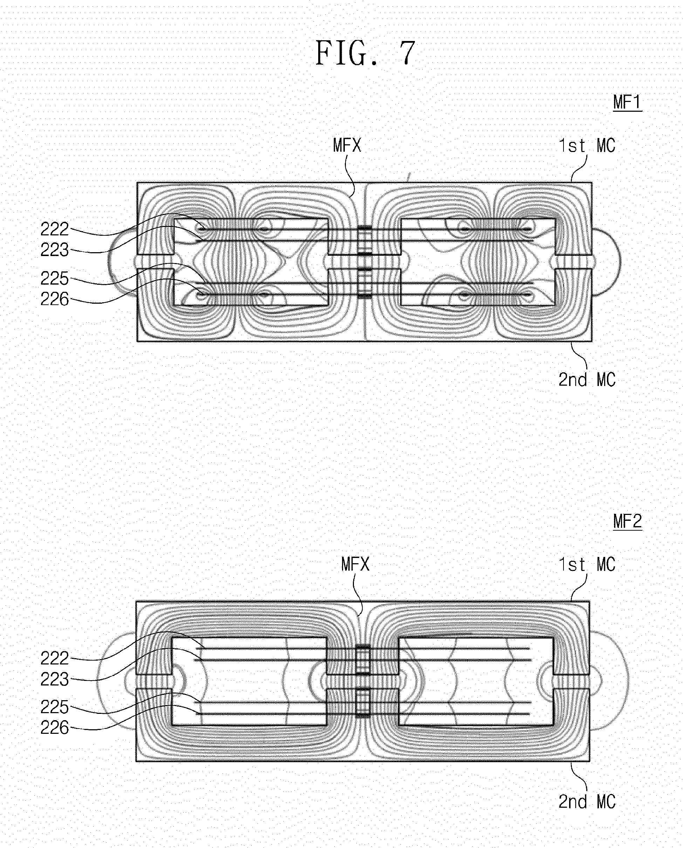

FIG. 7 is a diagram showing a magnetic field formed by an input coil and an output coil of a magnetic core transformer of FIG. 3. Referring to FIG. 7, the magnetic coupling of the input coils 222 and 225 and the output coils 223 and 226 may be identified.

A first magnetic field MF1 is a magnetic field formed by the input coils 222 and 225. According to the structure of the input coils 222 and 225 described above, a magnetic flux MFX is added to a region between the inner winding and outer winding of the input coils 222 and 225, and the magnetic flux MFX in an inner region of the inner winding and an outer region of the outer winding decreases.

A second magnetic field MF2 is a magnetic field formed by the output coils 223 and 226. Most of the magnetic flux MFX of the output coils 223 and 226 may be concentrated in the magnetic cores 1st MC and 2nd MC. Only some of the magnetic flux MFX among all the magnetic flux MFX may be coupled to both the input coils 222 and 225 and the output coils 223 and 226. In this way, it may be seen that coupling factors of the input coils 222 and 225 and the output coils 223 and 226 may be reduced.

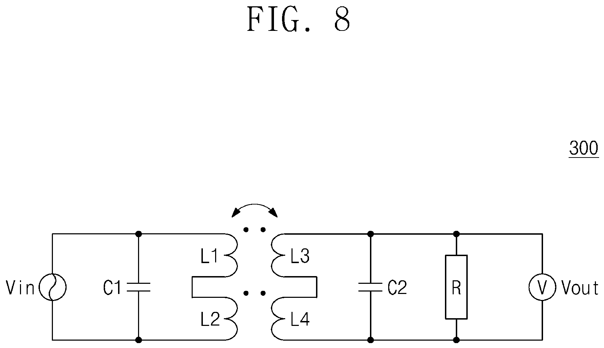

FIG. 8 is an RF equivalent circuit of the power supply of FIG. 2. Referring to FIG. 8, the power supply in FIG. 2 may be an RF equivalent circuit 300, and may be displayed as an input voltage Vin, a first capacitor C1, a first inductor L1, a second inductor L2, a third inductor L3, a fourth inductor L4, a second capacitor C2, a resistor R, and an output voltage Vout. In this case, the DC element in FIG. 2 may be ignored.

The first inductor L1 corresponds to the first input coil 222 in FIG. 2; the second inductor L2 corresponds to the second input coil 225; the third inductor L3 corresponds to the first output coil 223; and, the fourth inductor L4 corresponds to the second output coil 226. The first capacitor C1 corresponds to the matching capacitors 211 and 212 in FIG. 2. The second capacitor C2 corresponds to the variable capacitors 233 and 236 in FIG. 2, the capacitance of the quadrupole mass filter 250, and the capacitance of a connecting wire. The resistor R corresponds to the resistor of the loss occurring in the magnetic core MC of FIG. 2.

Self-inductances L11, L22, L33, and L44 of the inductors L1 to L4 in the RF equivalent circuit 300 is shown in Table 1.

**Table 1**

| Self-inductance [H] | |
|---|---|
| L11 | 3.0383E-7 |
| L22 | 3.0383E-7 |
| L33 | 5.5943E-5 |
| L44 | 5.5943E-5 |

Mutual inductances L12, L13, L14, L23, L24, and L34 of the inductors L1 to L4 in the RF equivalent circuit 300 is shown in Table 2 below.

**[Table 2]**

| Mutual inductance (sign is omitted) [H] | |
|---|---|
| L12 | 4.3847E-8 |
| L13 | 1.6486E-7 |
| L14 | 9.5247E-8 |
| L23 | 9.5249E-8 |
| L24 | 1.6486E-7 |
| L34 | 4.9344E-5 |

Coupling factors K12, K13, K14, K23, K24, and K34 of the inductors L1 to L4 in the RF equivalent circuit 300 are shown in Table 3 below.

**[Table 3]**

| Coupling factor | |
|---|---|
| K12 | 0.144314 |
| K13 | 0.039988 |
| K14 | 0.023103 |
| K23 | 0.023103 |
| K24 | 0.039988 |
| K34 | 0.882041 |

The capacitance of the first capacitor C1 is 1.61E-8 Farad (F); the capacitance of the second capacitor C2 is 5.355E-11 F; and, the resistance of the resistor R is 2.00E+5 ohm.

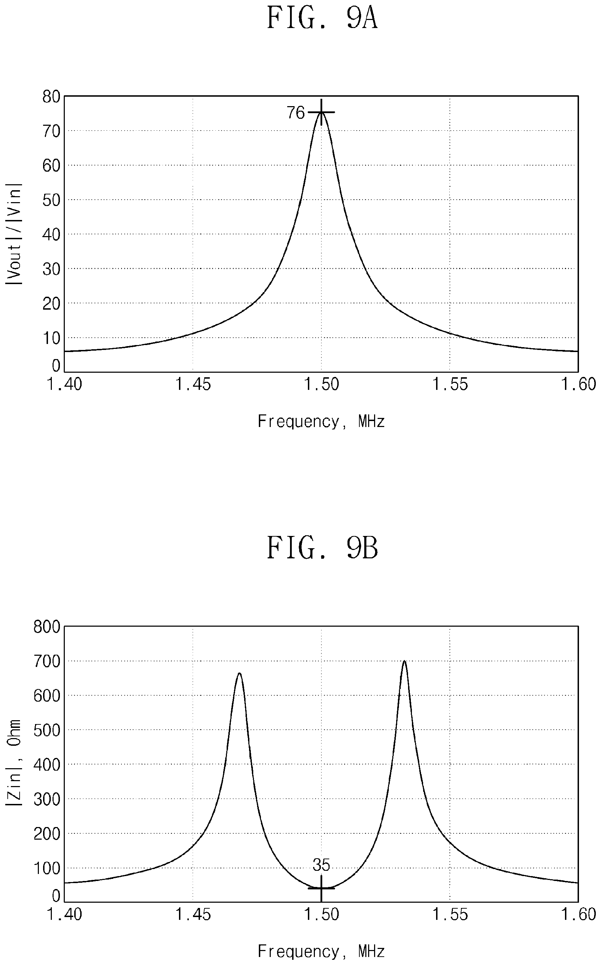

The RF equivalent circuit 300 may operate as a band pass filter. The band pass filter of the RF equivalent circuit 300 may be composed of a low impedance resonance tank including the first capacitor C1, the first inductor L1, and the second inductor L2, and a high impedance resonance tank including the second capacitor C2, the third inductor L3, and the fourth inductor L4. Hereinafter, the characteristics of the RF equivalent circuit 300 will be described in FIGS. 9A to 9C.

FIGS. 9A to 9C are graphs showing characteristics of the RF equivalent circuit of FIG. 8. Referring to FIG. 9A, an effective transformer factor of the RF equivalent circuit 300 may be identified. In the RF equivalent circuit 300, the turns ratio of the first inductor L1 and the third inductor L3 is 14. In other words, the number of turns of the first inductor L1 may be 1, and the number of turns of the third inductor L3 may be 14. However, due to the structural characteristics of the first inductor L1 and the second inductor L2 described above, the coupling factor K13 between the first inductor L1 and the third inductor L3 and the coupling factor K24 between the second inductor L2 and the fourth inductor L4 may have relatively small values. On the graph of FIG. 9A, an operating frequency is 1.50 megahertz (MHz), and the ratio of an input voltage Vin to an output voltage Vout at the operating frequency is 76. A transformer factor of a conventional magnetic core transformer needs to be the turns ratio of 14 or a value similar to 14. Meanwhile, it may be identified that the coupling factors K13 and K24 are reduced depending on the structure of the input coil according to the embodiment of the present disclosure, and thus the effective transformer factor reaches 76.

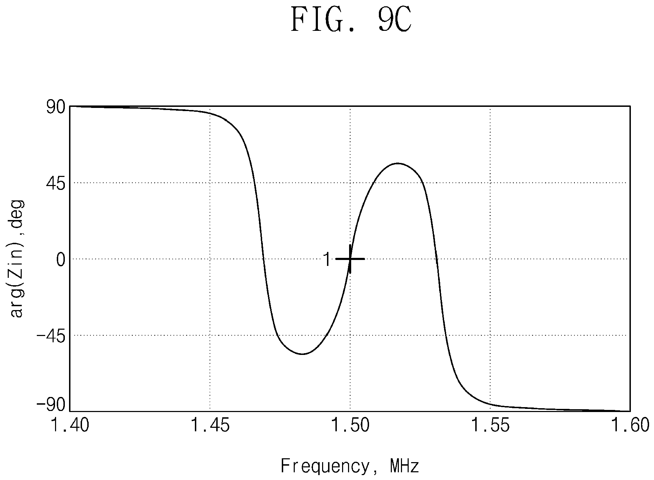

FIGS. 9B and 9C show the magnitude and phase of input impedance, respectively. At 1.5 MHz, which is an operating frequency of the RF equivalent circuit 300, the phase of input impedance becomes 0, and the magnitude of the input impedance has a minimum. In this case, it may be identified that the RF equivalent circuit 300 performs a band pass filter.

Hereinabove, although the embodiment of the present disclosure have been described with reference to the accompanying drawings, it will be understood by those skilled in the art to which the present disclosure pertains that the present disclosure may be carried out in other detailed forms without changing the technical spirits and essential features thereof. Therefore, the above-described embodiments are examples in all aspects, and should be construed not to be restrictive.

According to an embodiment of the present disclosure, a power supply, a magnetic core transformer, and a the printed circuit board PCB may achieve a transformer factor greater than a turns ratio of an input coil and an output coil through the structure of the input coil.

While the present disclosure has been described with reference to embodiments thereof, it will be apparent to those of ordinary skill in the art that various changes and modifications may be made thereto without departing from the spirit and scope of the present disclosure as set forth in the following claims.

## Claims

1. A power supply comprising:
a radio frequency (RF) power source;
a magnetic core transformer including a first transformer and a second transformer, each of which boosts an output of the RF power source;
direct current (DC) decoupling capacitors connected between a ground and a first terminal among output terminals of the first transformer and the second transformer;
variable capacitors connected between the ground and a second terminal among the output terminals of the first transformer and the second transformer;
a DC power source configured to provide a DC voltage to the first terminal;
an output terminal configured to output the DC voltage and a boosted RF voltage,
wherein each of the first transformer and the second transformer includes an input coil, a magnetic core, and an output coil,
wherein the input coil includes an outer winding and an inner winding, and
wherein the outer winding and the inner winding form a single turn winding, and the outer winding and the inner winding are connected in series to each other.

2. The power supply of claim 1, wherein the magnetic core of the first transformer and the magnetic core of the second transformer form an air gap.

3. The power supply of claim 1, further comprising:
matching capacitors connected in parallel to both ends of input coils of the first transformer and the second transformer.

4. The power supply of claim 3, wherein a size of each of the matching capacitors is determined to match leakage impedance of each of the input coils of the first transformer and the second transformer.

5. The power supply of claim 1, wherein a size of each of the DC decoupling capacitors is adjusted to form resonance with each of output coils of the first transformer and the second transformer, and each of the variable capacitors.

6. The power supply of claim 1, wherein each of the first transformer and the second transformer further includes a board, and
wherein the input coil is formed on a first surface of the board, and the output coil is formed on a second surface opposite to the first surface of the board.

7. The power supply of claim 6, wherein the board of the first transformer and the board of the second transformer are attached to face the output coil.

8. The power supply of claim 1, wherein a core of each of the first transformer and the second transformer is an E-shaped ferrite core.

9. A printed circuit board (PCB) comprising:
a board;
a first conductive line placed on one surface of the board; and
a second conductive line placed on a surface opposite to the one surface of the board,
wherein the first conductive line includes an inner winding and an outer winding, and
wherein the inner winding and the outer winding form a single turn winding, and the outer winding and the inner winding are connected in series to each other.

10. The PCB of claim 9, wherein the second conductive line is placed in a spiral shape.

11. A magnetic core transformer comprising:
a first magnetic core;
a second magnetic core; and
a first printed circuit board and a second printed circuit board, wherein a first conductive line is placed on one surface of each of the first printed circuit board and the second printed circuit board, and a second conductive line is placed on a surface opposite to the one surface,
wherein the first conductive line includes an inner winding and an outer winding, and
wherein the inner winding and the outer winding form a single turn winding, and the outer winding and the inner winding are connected in series to each other.

12. The magnetic core transformer of claim 11, wherein the first printed circuit board and the second printed circuit board are attached to each other through insulating adhesive.

13. The magnetic core transformer of claim 12, wherein the first printed circuit board and the second printed circuit board are attached to face a second conductive line.

14. The magnetic core transformer of claim 11, wherein the second conductive line of each of the first printed circuit board and the second printed circuit board is placed in a spiral shape.

15. The magnetic core transformer of claim 11, wherein a hole is formed in a center of each of the first printed circuit board and the second printed circuit board, and
wherein the first magnetic core passes through the hole of the first printed circuit board, and the second magnetic core passes through the hole of the second printed circuit board.

16. The magnetic core transformer of claim 15, wherein the first magnetic core and the second magnetic core form an air gap.

17. The magnetic core transformer of claim 16, wherein the air gap is adjusted to provide resonance at an operating frequency.

18. The magnetic core transformer of claim 11, wherein the first magnetic core and the second magnetic core are in an E-shape.

19. The magnetic core transformer of claim 11, wherein each of the first magnetic core and the second magnetic core is a ferrite core.
